# EUROPEAN PATENT APPLICATION

(11) **EP 4 757 572 A1**
(43) Date of publication of application: **10.06.2026**
(21) Application number: 25217895.9
(22) Date of filing: 24.11.2025
(51) Int. Cl.: H10W 10/40

(54) **METHOD FOR FILLING A HIGH ASPECT RATIO TRENCH**

(30) Priority: 04.12.2024 US 202463727845 P; 12.11.2025 US 202519386500
(71) Applicant: STMicroelectronics International N.V., 1228 Plan-les-Ouates, Geneva (CH)
(72) Inventor: DI STEFANO, Francesco, 569786 Singapore (SG); TAHIR, Fadhillawati, 644271 Singapore (SG); NGWAN, Voon Cheng, 732686 Singapore (SG); LO, Winnie Chen Sing, 760234 Singapore (SG); CHENG, Chin Siong, 530636 Singapore (SG)
(74) Representative: Casalonga

(57) **Abstract**

A method is provided for filling a high aspect ratio trench extending into the upper surface of a semiconductor substrate (114), comprising :
- a first filling phase which forms a conformal layer (134) ,
-an etch back to recess the portion of the conformal layer (134) extending over the upper surface of the semiconductor substrate (114) and form a funnel-shaped opening at the top of the trench,
-a second filling phase which forms a filling layer that fills the remainder of the trench including the funnel-shaped opening and extends over the upper surface of the semiconductor substrate,
- a further etch back to recess the portion of the filling layer extending over the upper surface of the semiconductor substrate (114).

## Description

### TECHNICAL FIELD

The present invention generally relates to a process for filling a high aspect ratio trench in a semiconductor substrate.

### BACKGROUND

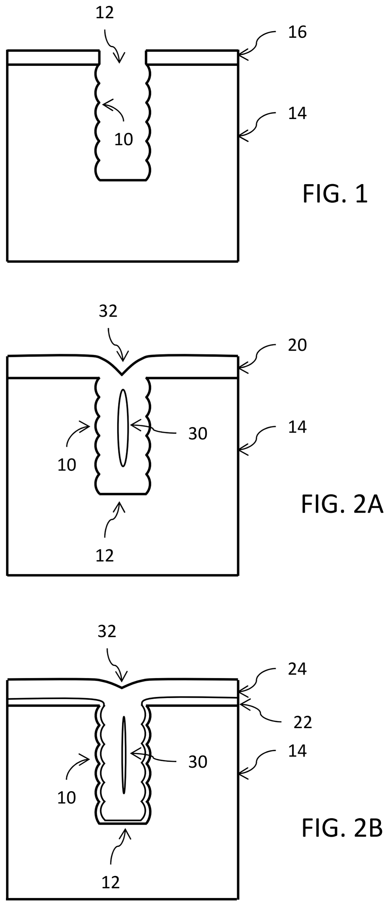

The rapid alternating process (RAP) or Bosch process are methods well known to those skilled in the art for performing deep silicon etching in the formation of high aspect ratio trenches. These processes are characterized by the repeated use of alternating etching and deposition cycles which result in the formation of "scallops" 10 in the sidewalls of the etched trench 12 as shown in Figure 1 (where reference 14 is a semiconductor, for example silicon, substrate, and reference 16 is a hard mask with an opening defining the location wherein the trench is to be etched). These scallops 10 are a direct result of the repeated alternating etching and deposition cycles (Note: the size and shape of the scalloped features as shown in the figures is exaggerated).

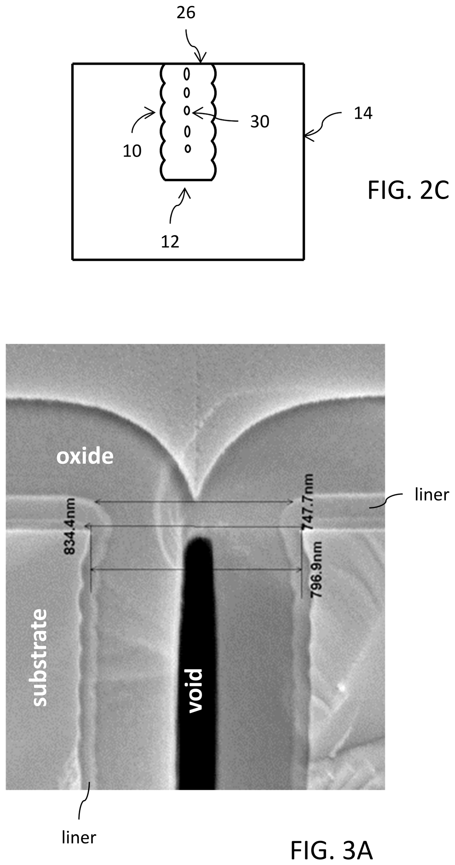

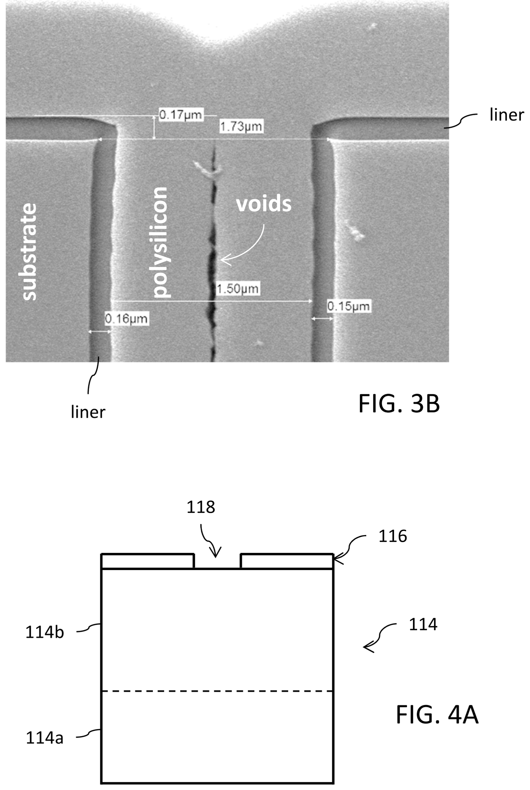

The trench 12 is then filled with a material selected dependent on the circuit application. For example, for forming a deep trench isolation (DTI) structure, the trench is filled with an insulating material 20 such as an oxide as shown in Figure 2A (where Figure 3A shows a corresponding scanning electron microscope (SEM) cross-sectional image). Alternatively, for another form of deep trench isolation (DTI) structure, the sidewalls and bottom of the trench are covered by an insulating liner 22 made of an oxide and the trench is filled with a highly resistive material 24 such as undoped polysilicon as shown in Figure 2B (where Figure 3B shows a corresponding scanning electron microscope (SEM) cross-sectional image). In yet another example for forming a trench super-junction type power transistor, the trench is filled with an epitaxial material 26 doped opposite to the substrate 14 as shown in Figure 2C.

Due to the negative slope profile of the trench 12 near the top of the trench and the high aspect ratio of the trench, there is a high risk of void 30 formation when filling the trench. These voids 30, especially when located near the top of the trench 12, can generate a high level of mechanical stress induced during subsequent high temperature annealing processes. As a result, a warpage or bowing of the semiconductor wafer can occur, and this can adversely affect accurate performance of subsequent wafer processing operations.

Additionally, if the voids 30 are too close to the top of the trench 12, there is a risk of exposing (i.e., opening) the voids during subsequent etching or recessing processes. This is a concern because undesired material, such as a metal, can then fill the voids.

The presence of voids 30 in the epitaxial fill material 26 as shown in Figure 2C can also have adverse effects on the charge balance, electric field and breakdown voltage of the trench super-junction type power transistor.

The filling of the trench 12 can also result in the formation of a topological depression 32 at the upper surface of the wafer. The high topological difference at the trench locations can have an adverse effect on wafer processing due to misalignment.

There is accordingly a need in the art to provide an improved and cost-effective method for filling high aspect ratio trenches formed in a semiconductor substrate.

### SUMMARY

An embodiment provides a method comprising: forming a high aspect ratio trench extending into a semiconductor substrate from an upper surface; in a first filling phase, forming a conformal layer made of a fill material that only partially fills the high aspect ratio trench and extends over the upper surface of the semiconductor substrate; performing a first etch back to recess a portion of the conformal layer which extends over the upper surface of the semiconductor substrate and form a funnel-shaped opening at a top of the trench; in a second filling phase, forming a filling layer, also made of the fill material, that fills a remainder of the trench including the funnel-shaped opening and extends over the upper surface of the semiconductor substrate; and performing a second etch back to recess a portion of the filling layer which extends over the upper surface of the semiconductor substrate to a level substantially coplanar with the upper surface of the semiconductor substrate.

In embodiments, the method further comprises one or more of the following features or combination thereof:
- forming a high aspect ratio trench comprises one of a Bosch etching process or a rapid alternating process (RAP) etching for trench formation ;
- the high aspect ratio trench has an aspect ratio greater than or equal to 10:1 ;
- the method further comprises, after the second filling phase and before the second etch back, performing a polishing of an upper surface of the filling layer ;
- the conformal layer has a first thickness and the filling layer has a second thickness greater than the first thickness ;
- the second thickness is about two times the first thickness ;
- the first thickness is about one-third a width of the high aspect ratio trench, and the second thickness is about two-thirds the width of the high aspect ratio trench ;
- the semiconductor substrate comprises a silicon substrate layer and an overlying epitaxial layer, and wherein the high aspect ratio trench extends completely through the overlying epitaxial layer and partially into the silicon substrate layer ;
- the method further comprises, before the first filling phase, thermally oxidizing to form an oxide liner on the upper surface of the semiconductor substrate and sidewalls and a bottom of the high aspect ratio trench ;
- the method further comprises, removing the oxide liner before the first filling phase ;
- the filling material in the first filling phase is a semiconductor material grown from the semiconductor substrate ;
- the filling material in the first filling phase is an oxide insulating material in contact with the oxide liner ;
- the filling material in the first filling phase is an undoped polysilicon material in contact with the oxide liner.

In an embodiment, it is provided a method comprising: forming a high aspect ratio trench extending into a semiconductor substrate from an upper surface; lining the upper surface of the semiconductor substrate and sidewalls and a bottom of the high aspect ratio trench with an insulating liner; in a first filling phase, forming a conformal layer in contact with the oxide liner, wherein the conformal layer is made of a fill material, said conformal layer only partially filling the high aspect ratio trench and extending over the upper surface of the semiconductor substrate; performing a first etch back to recess a portion of the conformal layer which extends over the upper surface of the semiconductor substrate and form a funnel-shaped opening at a top of the trench; in a second filling phase, forming a filling layer in contact with the conformal layer, wherein the filling layer is also made of the fill material, said filling layer completely filling a remainder of the trench including the funnel-shaped opening and extending over the upper surface of the semiconductor substrate; and performing a second etch back to recess a portion of the filling layer which extends over the upper surface of the semiconductor substrate to a level substantially coplanar with the upper surface of the semiconductor substrate.

In embodiments, the method further comprises one or more of the following features or combination thereof:
- the filling material in the first filling phase is an oxide insulating material ;
- the filling material in the first filling phase is an undoped polysilicon material ;
- the high aspect ratio trench has an aspect ratio greater than or equal to 10:1 ;
- the insulating liner is formed by thermally oxidizing the semiconductor substrate.

In an embodiment, it is provided a method comprising: forming a high aspect ratio trench extending into a semiconductor substrate from an upper surface; thermally oxidizing the upper surface of the semiconductor substrate and sidewalls and a bottom of the high aspect ratio trench with an insulating liner; removing the insulating liner to expose the semiconductor substrate; in a first filling phase, forming a conformal layer by epitaxial growth from the exposed semiconductor substrate, wherein the conformal layer is made of a semiconductor material, said conformal layer only partially filling the high aspect ratio trench and extending over the upper surface of the semiconductor substrate; performing a first etch back to recess a portion of the conformal layer which extends over the upper surface of the semiconductor substrate and form a funnel-shaped opening at a top of the trench; in a second filling phase, forming a filling layer by epitaxial growth from the conformal layer, wherein the filling layer is also made of the semiconductor material, said filling layer completely filling a remainder of the trench including the funnel-shaped opening and extending over the upper surface of the semiconductor substrate; and performing a second etch back to recess a portion of the filling layer which extends over the upper surface of the semiconductor substrate to a level substantially coplanar with the upper surface of the semiconductor substrate.

In embodiments, the method further comprises one or more of the following features or combination thereof:
- the high aspect ratio trench has an aspect ratio greater than or equal to 10:1

### BRIEF DESCRIPTION OF THE DRAWINGS

For a better understanding of the embodiments, reference will now be made by way of example only to the accompanying figures in which:
Figure 1 illustrates a cross section of a trench formed using a Bosch process showing the presence of scalloped sidewall surface roughness;
Figures 2A-2C show cross-sectional views of a high aspect ratio trench formed by the Bosch process and incompletely filled with different materials and trench center void formation;
Figures 3A-3B are scanning electron microscope (SEM) cross-sectional images of filled trenches corresponding to Figures 2A-2B;
Figures 4A-4H illustrate steps in an improved process for forming and filling a high aspect ratio trench; and
Figure 5 is a SEM cross-sectional image of the filled trench corresponding to Figure 4H.

### DETAILED DESCRIPTION

Reference is made to Figures 4A-4H which illustrate steps in process for forming and filling a high aspect ratio trench.

Figure 4A - a hard mask 116 is formed on the upper surface of a semiconductor (for example, silicon) substrate 114 and patterned to include a mask opening 118 at the location where it is desired to form a trench. The substrate 114 may, for example, comprise a silicon substrate layer 114a and an overlying epitaxial layer 114b.

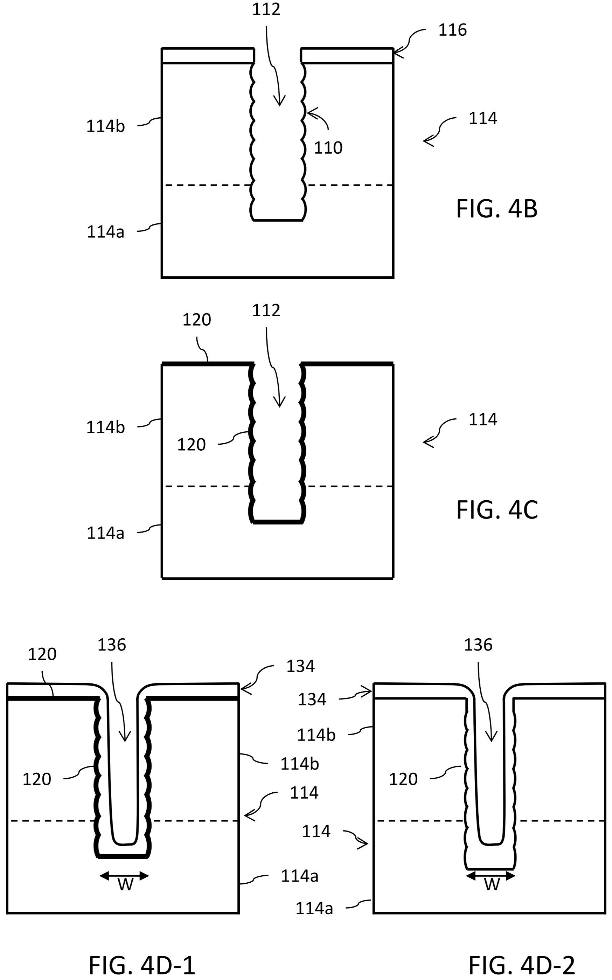

Figure 4B - using a rapid alternating process (RAP), or Bosch etch process, as is well known to those skilled in the art, repeated alternating etching and deposition cycles are performed to open a trench 112 in the substrate 114 to a depth which, for example, passes completely through the epitaxial layer 114b and partially into the substrate layer 114a. It is noted that the RAP/Bosch etch process produces a trench sidewall surface roughness defined by scalloped features 110 (Note: the size and shape of the scalloped features as shown in the figures is exaggerated). The trench 112 has a high aspect ratio which, in the context of this disclosure and the claims, is understood to mean and refer to a ratio that is greater than or equal to 10:1 (depth:width).

Figure 4C - a thermal oxidation is performed to oxidize the upper surface of the substrate 114 and the sidewalls and bottom of the trench 112 forming an oxide layer 120 that lines the inside of the trench 112.

Figure 4D-1 - a conformal layer 134 of a desired material for filling the trench 112 is then provided on the oxide layer 120 during a first filling phase. This conformal layer 134 partially fills the trench 112 leaving an opening 136. The conformal layer 134 may comprise a deposited, for example using a low pressure chemical vapor deposition (LPCVD), insulating material such as an oxide or a highly resistive material such as an undoped polysilicon material.

Alternatively, the conformal layer 134 may comprise a semiconductor material that is epitaxially grown from the semiconductor material of the substrate (in which case the oxide layer 120 lining the trench sidewalls and bottom is selectively removed to expose the semiconductor substrate prior to performing the epitaxial growth). See, Figure 4D-2. The removal of the oxide layer 120 may provide for a smoothing of the scallop shape at the sidewalls of the trench.

A thickness of the conformal layer 134 is selected to ensure that the trench 112 is not substantially or completely filled. For example, the conformal layer 134 may have a thickness that is between 25-35% of the width W of the trench 114 so as to leave the opening 136.

Note: for the remaining description of the process, the configuration of the trench including the oxide liner 120 as shown in Figure 4D-1 is utilized, but it will be understood that the process steps are equally applicable to the implementation shown in Figure 4D-2 for the trench which does not include liner 120.

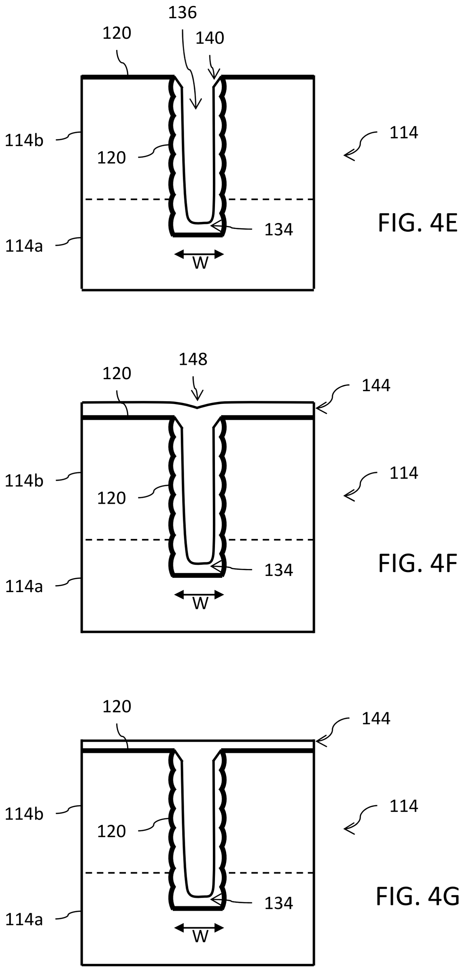

Figure 4E - an etch back (for example of anisotropic type) is then performed to recess the portion of the conformal layer 134 located over the upper surface of the substrate. The etch back may, for example, comprise a poly etch back using Cl₂/HBr/HeO₂ chemistry, where the etch process is controlled by endpoint and followed by a defined over etch. This etch back may, for example, be stopped when the oxide layer 120 on the upper surface of the substrate 112, if present, is reached. The etch back will also remove a portion of the conformal layer 134 within the trench near the upper surface of the substrate 112 forming a tapered funnel-shaped opening 140 at the top of the opening 136 due to the anisotropic properties of the etch. The surface of the tapered opening 140 may, generally speaking, be defined by the surface of an up-side-down truncated cone.

Figure 4F - a conformal layer 144 of the desired material for filling the trench 112 is then provided on the oxide layer 120 (or on the upper surface of layer 114b in the Figure 4D-2 implementation) at the upper surface of the substrate 112 and on the conformal layer 134 located within the trench 112 during a second filling phase. The presence of the tapered opening 140 near the top of the trench 112 supports filling of the opening 136 without formation of voids (compared to Figures 2A-2C, reference 30). Additionally, the partial filling of the trench with conformal layer 134 first before filling with conformal layer 144 results in a less severe topological depression 148 at the upper surface of the semiconductor wafer (compared to Figures 2A-2C, reference 32). The conformal layer 144 may comprise a deposited insulating material such as an oxide material matching the material of layer 134. The conformal layer 144 may comprise a deposited highly resistive material such as an undoped polysilicon material matching the material of layer 134. These depositions may, for example, be accomplished using a low pressure chemical vapor deposition (LPCVD) process.

In the alternative implementation associated the structure of Figure 4D-2, the conformal layer 144 may comprise a semiconductor material matching the material of layer 134 that is epitaxially grown from the semiconductor material of layer 134.

A thickness of the conformal layer 144 is selected to ensure that the remaining openings 136, 140 in the trench 112 are completely filled. For example, the conformal layer 144 may have a thickness that is about two times (plus/minus 10%) the thickness of the conformal layer 134.

Figure 4G - a polishing operation is then performed to planarize the upper surface of the conformal layer 144 over the substrate 112. This polishing operation may, for example, comprise a chemical-mechanical polishing (CMP).

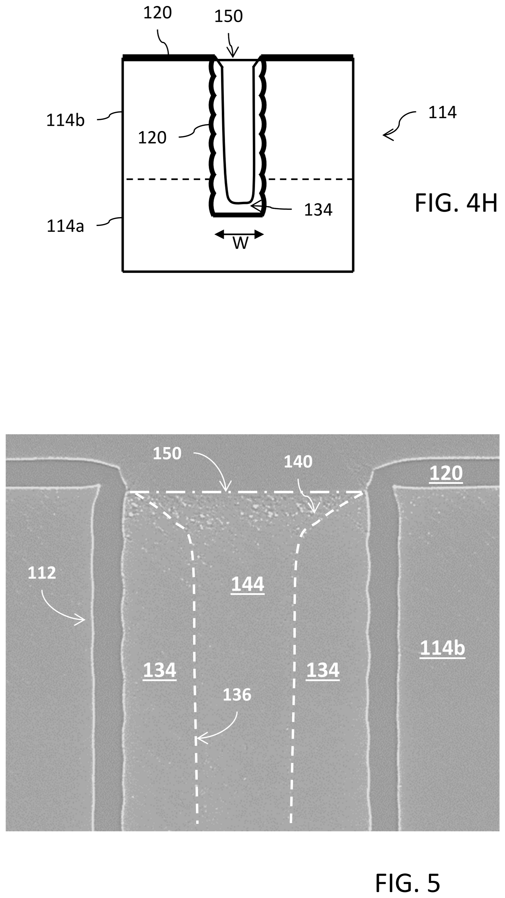

Figure 4H - an etch back (for example of anisotropic type) is then performed to recess the conformal layer 144 to a surface level 150 substantially coplanar with the upper surface of the substrate 112. In this context, substantially coplanar means that the upper surface of the substrate 112 and the surface level 150 are at or near the same elevation subject to the tolerances of the etch stopping control limits of the manufacturing process used for the etch back operation. As an example, substantially coplanar means that any surface offset difference in a vertical direction is less than or equal to 0.1 µm. The etch back may, for example, comprise a poly etch back using Cl₂/HBr/HeO₂ chemistry, where the etch process is controlled by endpoint and followed by a defined over etch. The combination of the polishing operation of Figure 4G and the etch back of Figure 4H provides an upper surface of the filled trench that is flattened, for example to a level coplanar with the upper surface of the substrate, thus obviating concerns with presence of a high topological difference at trench locations that are a problem with previous solutions like that shown in Figure 2A-2B.

Figure 5 is an annotated SEM cross-sectional image corresponding to Figure 4H. Because the material conformal layers 134, 144 is the same material, a distinction between the two layers is not readily visible in the SEM image. The annotated dotted lines show the general location differentiating the layers 134, 144.

Example: for a trench 112 having a width in a range of 0.5 to 2 µm and a depth in a range of 5 to 40 µm (in other words, a trench having an aspect ratio in a range of about 10:1 to 20:1), the conformal layer 134 may have a thickness in a range of 2 to 10 kÅ and the conformal layer 144 may have a thickness in a range of 4 to 20 kÅ. It will be noted that the process of Figure 4A for forming the trench provides a trench having a highly vertical sidewall profile. The etch back of Figure 4E recesses the full thickness of layer 134 from above the substrate and forms the tapered funnel-shaped opening 140. The polishing operation of Figure 4G thins the layer 144 above the substrate by about one-half its thickness. The etch back of Figure 4H recesses the remaining thickness of layer 144 from above the substrate and forms the coplanar upper surface with substrate 112. The filled trench exhibits no voids at least in the upper half of the trench depth.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

## Claims

1. A method, comprising:
forming a high aspect ratio trench (112) extending into a semiconductor substrate (114) from an upper surface;
in a first filling phase, forming a conformal layer (134) made of a fill material that only partially fills the high aspect ratio trench and extends over the upper surface of the semiconductor substrate (114);
performing a first etch back to recess a portion of the conformal layer (134) which extends over the upper surface of the semiconductor substrate and form a funnel-shaped opening (136) at a top of the trench;
in a second filling phase, forming a filling layer (144), also made of the fill material, that fills a remainder of the trench (112) including the funnel-shaped opening (136) and extends over the upper surface of the semiconductor substrate; and
performing a second etch back to recess a portion of the filling layer (144) which extends over the upper surface of the semiconductor substrate (114) to a level substantially coplanar with the upper surface of the semiconductor substrate.

2. The method of claim 1, wherein forming a high aspect ratio trench (112) comprises one of a Bosch etching process or a rapid alternating process (RAP) etching for trench formation.

3. The method of claim 1, wherein the high aspect ratio trench (112) has an aspect ratio greater than or equal to 10:1.

4. The method of claim 1, further comprising, after the second filling phase and before the second etch back, performing a polishing of an upper surface of the filling layer (144).

5. The method of claim 1, wherein the conformal layer (134) has a first thickness and the filling layer has a second thickness greater than the first thickness.

6. The method of claim 5, wherein the second thickness is about two times the first thickness.

7. The method of claim 5, wherein the first thickness is about one-third a width (W) of the high aspect ratio trench (112), and the second thickness is about two-thirds the width (W) of the high aspect ratio trench (112).

8. The method of claim **1,** wherein the semiconductor substrate (114) comprises a silicon substrate layer (114a) and an overlying epitaxial layer (114b), and wherein the high aspect ratio trench (112) extends completely through the overlying epitaxial layer and partially into the silicon substrate layer.

9. The method of claim 1, further comprising, before the first filling phase, thermally oxidizing to form an oxide liner (120) on the upper surface of the semiconductor substrate (114) and sidewalls and a bottom of the high aspect ratio trench (112).

10. The method of claim 9, further comprising, removing the oxide liner (120) before the first filling phase.

11. The method of claim 10, wherein the filling material in the first filling phase is a semiconductor material grown from the semiconductor substrate (114).

12. The method of claim 9, wherein the filling material in the first filling phase is an oxide insulating material in contact with the oxide liner (120).

13. The method of claim 9, wherein the filling material in the first filling phase is an undoped polysilicon material in contact with the oxide liner (120).

14. The method of claim 1, further comprising:
further comprising, before the first filling phase, lining the upper surface of the semiconductor substrate (114) and sidewalls and a bottom of the high aspect ratio trench with an insulating liner (120);
wherein the conformal layer (134) is further in contact with the insulating liner (120), and the filling layer (144) is further in contact with the conformal layer (134), said filling layer completely filling said remainder of the trench (112).

15. The method of claim 14, wherein the filling material (134) in the first filling phase is an oxide insulating material.

16. The method of claim 14, wherein the filling material (134) in the first filling phase is an undoped polysilicon material.

17. The method of claim 14, wherein the high aspect ratio trench (112) has an aspect ratio greater than or equal to 10:1.

18. The method of claim 14, wherein the insulating liner (120) is formed by thermally oxidizing the semiconductor substrate (114).

19. The method according to claim 1, comprising:
thermally oxidizing the upper surface of the semiconductor substrate (114) and sidewalls and a bottom of the high aspect ratio trench with an insulating liner (120);
removing the insulating liner to expose the semiconductor substrate (114);
in said first filling phase, forming said conformal layer (134) by epitaxial growth from the exposed semiconductor substrate (114), wherein the conformal layer is made of a semiconductor material ;
in said second filling phase, forming said filling layer (144) by epitaxial growth from the conformal layer, wherein the filling layer is also made of the semiconductor material, said filling layer completely filling said remainder of the trench ().

20. The method of claim 19, wherein the high aspect ratio trench (112) has an aspect ratio greater than or equal to 10:1.
